# EUROPEAN PATENT APPLICATION

(11) **EP 3 225 372 A1**
(43) Date of publication of application: **04.10.2017**
(21) Application number: 15864048.2
(22) Date of filing: 26.11.2015
(51) Int. Cl.: B28D 5/00, B28D 5/04

(54) **SUBSTRATE PROCESSING TOOL**

(30) Priority: 27.11.2014 JP 2014239831
(71) Applicant: Mitsuboshi Diamond Industrial Co., Ltd., Settsu Osaka 566-0034 (JP)
(72) Inventor: HIRAGURI, Yosuke, Settsu city Osaka 566-0034 (JP); OGASAWARA, Noriyuki, Settsu city Osaka 566-0034 (JP); SATO, Shinichi, Settsu city Osaka 566-0034 (JP)
(74) Representative: TBK
(86) International application number: PCT/JP2015/083189
(87) International publication number: WO 2016/084884

(57) **Abstract**

A substrate processing tool is prevented from falling out of a tool holder. This substrate processing tool (1) is a tool for attachment to a substrate processing apparatus. The substrate processing tool (1) includes a tool main body (2), a blade edge portion (3), and an engaging portion (4). A holding portion that is to be held by the chuck portion of the substrate processing apparatus is formed in at least a portion of the tool main body (2). The blade edge portion (3) is formed on one end side of the tool main body (2). The engaging portion (4) is formed on the other end side of the tool main body (2), and protrudes farther than the surface of the tool main body (2).

## Description

### TECHNICAL FIELD

The present invention relates to a processing tool, and in particular to a substrate processing tool for attachment to a substrate processing apparatus.

### BACKGROUND ART

Mechanical scribing apparatuses are used to form cell separation grooves in thin film solar cell substrates. These apparatuses utilize a circular tool that has a blade edge at its tip (e.g., see Patent Literature 1).

The aforementioned tool is manufactured by grinding a round bar base member. Specifically, the round bar base member is attached to the chuck of a cylindrical grinder, and the tip is ground while rotating the base member in order to form the blade edge.

### CITATION LIST

### PATENT LITERATURE

Patent Literature 1: JP 2004-115356A

### SUMMARY

### TECHNICAL PROBLEM

The substrate processing tool is attached to the processing head of the scribing apparatus. Specifically, the scribing apparatus is provided with a processing head that can move relative to a work table on which a substrate is placed. Generally, multiple head units are arranged side-by-side in the processing head. A tool is removably attached to each of the head units via a tool holder.

In this configuration, the tool is gripped by a chuck of the tool holder, but there is a risk of the tool falling out due to vibration during processing or the like.

A problem to be solved by the present invention is preventing the substrate processing tool from falling out of the tool holder.

### SOLUTION TO PROBLEM

A substrate processing tool according to one aspect of the present invention is a tool for attachment to a substrate processing apparatus. This substrate processing tool includes a tool main body, a blade edge portion, and an engaging portion. A holding portion to be held by a chuck portion of the substrate processing apparatus is formed in at least a portion of the tool main body. The blade edge portion is formed on one end side of the tool main body. The engaging portion is formed on another end side of the tool main body, and protrudes farther than a surface of the tool main body.

The holding portion formed in the tool main body of this tool is held by a substrate processing apparatus. In this case, the engaging portion is formed on the other end side of the tool main body, and therefore by providing the substrate processing apparatus with a portion for engaging with this engaging portion from below, it is possible to prevent the tool from falling downward due to vibration during processing or the like.

Also, when the holding portion and the blade edge portion of the tool main body are processed during manufacturing of the tool, the side of the tool main body that is opposite to the blade edge portion (the other end side) is attached to the chuck portion of the apparatus for processing the tool. Accordingly, after the holding portion and the blade edge portion are processed, an unprocessed portion remains on the other end side of the tool main body. This unprocessed portion protrudes out from the surface of the tool main body that was ground, and a level difference is formed between the unprocessed portion and the tool main body. By leaving this unprocessed portion and not removing it, it is possible to obtain the engaging portion.

In the substrate processing tool according to another aspect of the present invention, a character is printed on the engaging portion, and no character is printed on the tool main body.

The engaging portion protrudes farther than the holding portion that is to be held by the substrate processing apparatus, and there is a clear distinction from the holding portion, and therefore even if the printed portion rises up or deforms, the positional precision of the tool held by the substrate processing apparatus does not degrade due to the printing.

In the substrate processing tool according to yet another aspect of the present invention, the tool main body has a circular cross-sectional shape. Also, the engaging portion has a circular cross-sectional shape and has a larger diameter than an outer diameter of the tool main body.

In the case where the tool is manufactured by grinding a round bar base member, generally the base member is attached to a tool processing apparatus such as a cylindrical grinder, and then the tool main body is ground. With this processing method, the portion of the base member that is attached to the tool processing apparatus will remain unprocessed and have a larger diameter than the tool main body.

In view of this, by using this unprocessed portion as the engaging portion, the engaging portion can be obtained without any processing.

In the substrate processing tool according to still another aspect of the present invention, the holding portion has a circular cross-sectional shape. Also, the blade edge portion has a circular cross-sectional shape, and decreases in diameter from the holding portion toward a tip.

In this case, the holding portion and the blade edge portion can both be processed in the same step in the state where the base member is attached to the chuck of a tool processing apparatus such as a cylindrical grinder. For this reason, it is possible to prevent shifting between the center of the holding portion of the tool and the center of the blade edge portion.

In the substrate processing tool according to still another aspect of the present invention, the holding portion and the blade edge portion are formed in the same step in a state where the tool is held by a chuck of a tool processing apparatus.

In this case, as previously described, it is possible to prevent shifting between the center of the holding portion of the tool and the center of the blade edge portion.

### ADVANTAGEOUS EFFECTS

With the above-described present invention, it is possible to prevent a substrate processing tool from falling out of a tool holder due to vibration during processing or the like.

### BRIEF DESCRIPTION OF DRAWINGS

Fig. 1 is an external view of a tool manufactured by a method according to one embodiment of the present invention.
Fig. 2 is a schematic diagram for describing a method for manufacturing the tool of Fig. 1.
Fig. 3 is an external perspective view of a scribing apparatus to which the tool of the present invention is attached.
Fig. 4A is a side view of a tool holder that holds the tool of the present invention.
Fig. 4B is a front view of the tool holder that holds the tool of the present invention.
Fig. 5 is an enlarged partial view of the tool holder.
Fig. 6 is an external view of another embodiment of the tool.

### DESCRIPTION OF EMBODIMENTS

### Tool

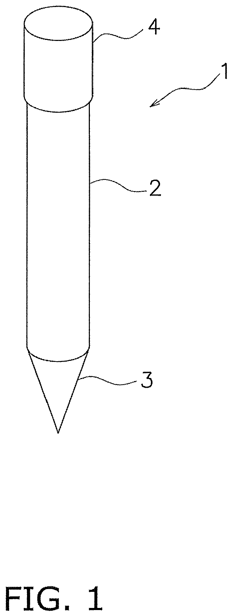

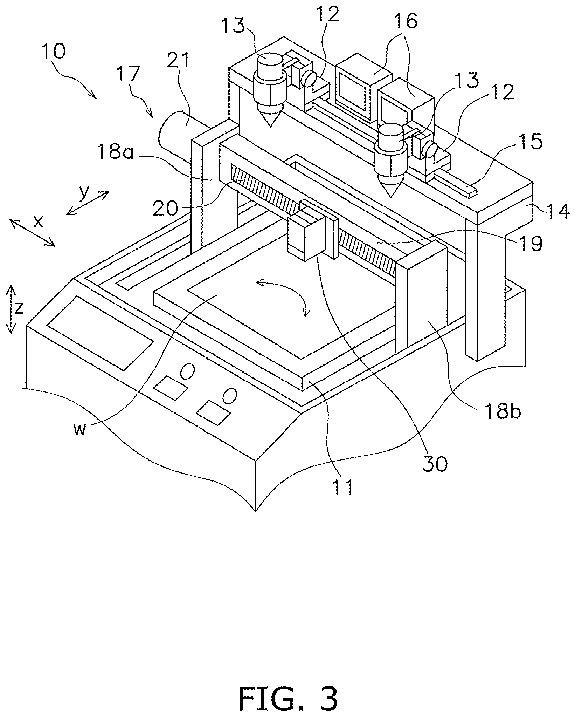

An external view of a substrate processing tool 1 according to one embodiment of the present invention is shown in Fig. 1. This tool 1 is attached to a scribing apparatus 10 (substrate processing apparatus) shown in Fig. 3 and used to form insulation grooves in a thin film solar cell substrate.

The tool 1 has a tool main body 2, a blade edge portion 3 formed on end side of the tool main body 2, and a processing support portion (engaging portion) 4 formed on the other end side of the tool main body 2. This tool 1 is formed by using a cylindrical grinder to grind a round bar base member.

The tool main body 2 is shaped as circular column, and has the same outer diameter over its entire length. One portion of the tool main body 2 functions as a holding portion that is held in the scribing apparatus 10 (described in detail later). The blade edge portion 3 is shaped as a cone that decreases in diameter from the tool main body 2 toward one end side. Note that the tip of the blade edge portion 3 is formed such that the blade width is 40 µm, for example. Accordingly, the blade edge portion 3 is more accurately shaped as a truncated cone. The processing support portion 4 is the portion that is attached to a chuck of the cylindrical grinder when the tool 1 is to be ground by the cylindrical grinder, and is gripped by claws of the chuck. This processing support portion 4 has a larger diameter than the tool main body 2, and a level difference is formed between the tool main body 2 and the processing support portion 4.

### Tool manufacturing method

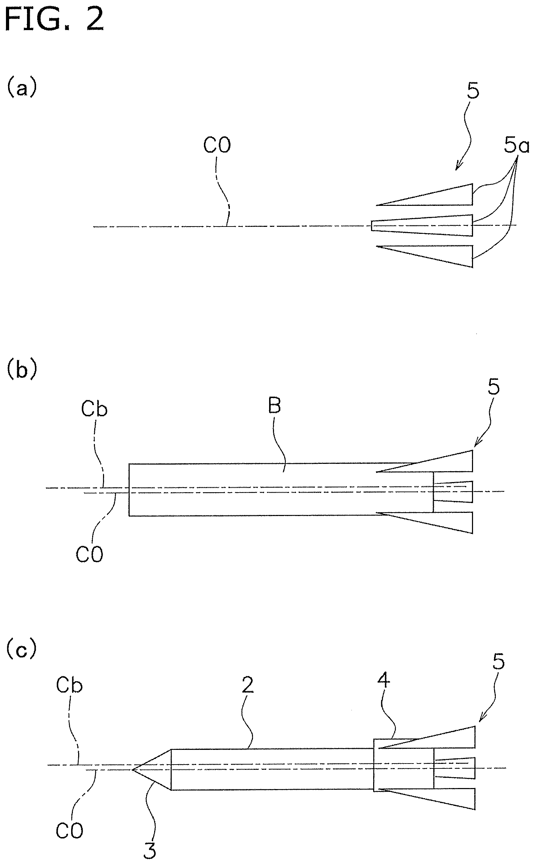

As previously described, the tool 1 is attached to a cylindrical grinder chuck 5 shown in Fig. 2 in order to be processed. Fig. 2(a) schematically shows claws 5a of the cylindrical grinder chuck 5. In Fig. 2(a), C0 is the center of the chuck 5 (rotation axis of the cylindrical grinder).

When the tool 1 is to be processed, a tool base member B is attached to the cylindrical grinder chuck 5 as shown in Fig. 2(b). In Fig. 2(b), the center (center axis) of the base member is indicated by Cb. In this example, when the base member B is attached to the chuck 5, the center C0 of the chuck 5 is shifted from the center Cb of the base member B.

The base member B in the above state is ground while being rotated, thus forming the blade edge portion 3 and the tool main body 2 that serves as the holding portion. Specifically, the tool main body 2 and the blade edge portion 3 are processed without removing the base member B from the chuck 5, and while keeping the base member B in the same orientation while attached to the chuck 5. During this processing, the tool main body 2 is ground to the same diameter over its entire length, and the tool main body 2 and the blade edge portion 3 are successively processed using the same grinding stone. The blade edge portion 3 is then processed such that the blade width of the tip becomes 40 µm for example.

The state resulting from the above processing is shown in Fig. 2(c). Due to performing this processing, the center of the holding portion (one portion of the tool main body 2) that is to be held by the scribing apparatus 10 and the center of the blade edge portion 3 for processing a substrate both become Cb and match each other. Accordingly, if tools processed by this method are used, even when a tool is replaced, there is almost no change in the position of the blade edge before and after the replacement.

Due to performing the above processing, the unprocessed processing support portion 4 attached to the cylindrical grinder chuck 5 has a larger diameter than the outer diameter of the tool main body 2. Accordingly, this processing support portion 4 can be used as an engaging portion for engaging with a portion of the scribing apparatus 10 when the processing support portion 4 is attached to the scribing apparatus 10.

### Scribing apparatus 10

Fig. 3 will be used to briefly describe the scribing apparatus 10 to which the tool 1 manufactured as described above is attached.

The scribing apparatus 10 includes a table 11 on which a thin film solar cell substrate W is placed. The table 11 can move in the y direction in Fig. 3 in the horizontal plane (xy plane), and can rotate to any angle in the horizontal plane. A camera 13 is attached to each of two stands 12 above the table 11. The stands 12 can move along a guide 15 that extends in the x direction and is provided on a support 14. The two cameras 13 can move up and down, and the images captured by the cameras 13 are displayed on corresponding monitors 16.

A bridge 17 is provided above the table 11. The bridge 17 has a pair of support columns 18a and 18b, a guide bar 19, and a motor 21. The guide bar 19 is provided spanning between the pair of support columns 18a and 18b in the x direction. The motor 21 drives a guide 20 formed on the guide bar 19. Also, the bridge 17 holds a processing head 30 that can move along the guide 20 in the x direction in the horizontal plane.

### Attachment of tool 1 to scribing apparatus 10

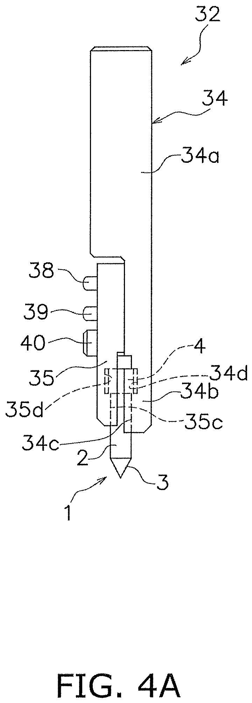

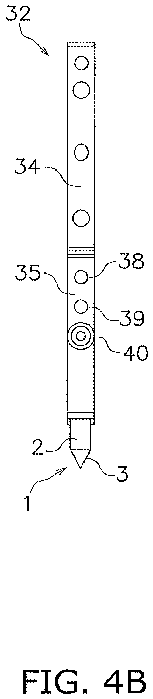

The tool 1 of the present embodiment is removably attached to the lower end of a tool holder 32 shown in Figs. 4A and 4B. Note that although not described in detail, the tool holder 32 is attached to the head unit, and multiple head units are arranged side-by-side with a constant gap therebetween on the processing head 30 of the scribing apparatus 10. Fig. 4A is a side view of the tool holder 32, and Fig. 4B is a front view of the same.

The tool holder 32 is shaped as an elongated parallelepiped. The tool holder 32 has a base plate 34 with a partial cutout, and a cover plate 35 that is attached to the cutout portion of the base plate 34.

The base plate 34 has a processing head attachment portion 34a in the upper portion, and a tool attachment portion 34b for fixing the tool 1 at the lower end. The tool attachment portion 34b has been cut so as to be thin in the lower portion as shown in Fig. 4A. Two reference pins 38 and 39 are inserted into the base plate 34 and the cover plate 35 in the upper portion of this cutout portion. The base plate 34 and the cover plate 35 are positioned by the two reference pins 38 and 39, and are fixed by a screw member 40.

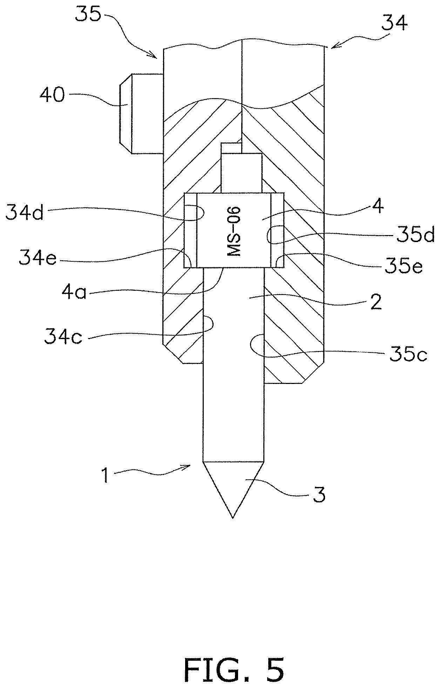

Fig. 5 shows an enlargement of a cross-section of a portion of Fig. 4A. As shown in Fig. 5, portions 34c and 35c for holding the tool 1 by coming into contact with a portion of the tool main body 2 (holding portion) are respectively formed on the base plate 34 and the cover plate 35. Also, clearance portions 34d and 35d for preventing contact with the processing support portion 4 of the tool 1 are respectively formed above the tool holding portions 34c and 35c of the base plate 34 and the cover plate 35.

Lower surfaces 34e and 35e of the clearance portions 34d and 35d are formed so as to engage with a lower surface 4a (level different portion) of the processing support portion 4 of the tool 1. For this reason, when the tool 1 is fixed so as to be sandwiched by the base plate 34 and the cover plate 35, it is possible to reliably prevent the tool 1 from falling downward due to vibration or the like.

Note that a magnet 42 for coming into contact with the upper surface of the processing support portion 4 of the tool 1 is provided in order to provisionally fix the tool 1 in the state of being inserted between the two plates 34 and 35 before the screw member 40 is fastened when attaching the tool 1 to the tool holder 32.

Also, the model number or the like is printed on a side surface of the processing support portion 4 of the tool 1 shown in Fig. 5 using laser marking or ink, and nothing is printed on the holding portion of the tool main body 2. The printed portion may deform or become raised due to laser processing or ink, but nothing is printed on the tool main body 2 that comes into contact with the tool holding portions 34c and 35c, and therefore the printing on the tool does not influence the tool attachment position. Moreover, the processing support portion 4 protrudes farther than the tool main body 2, and therefore the position of the tool does not shift such that the processing support portion 4 comes into contact with the tool holding portions 34c and 35c, and it is possible to prevent change in the tool attachment position caused by the printing on the tool.

### Other embodiments

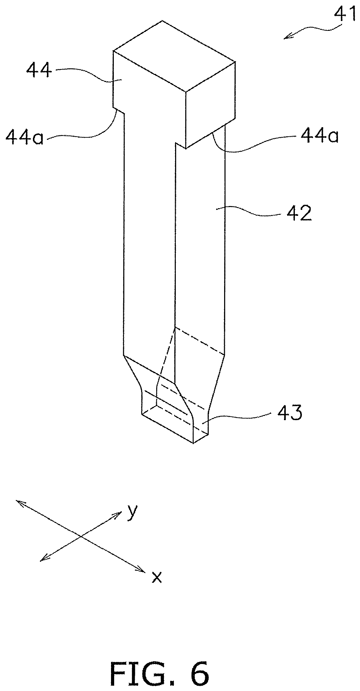

The present invention is not limited to the embodiment described above, and various modifications and alterations can be made without departing from the scope of the present invention.
(a) Although a cylindrical grinder and a grinding stone are used to perform grinding to manufacture the tool in the above embodiment, the processing apparatus and processing tool used to manufacture the tool are not limited to this, and grinding may be performed using a lathe and a cutting tool, for example.
(b) There are no particular limitations on the sequence in which the holding portion 2 and the blade edge portion 3 are formed. The blade edge portion 3 may be formed after the holding portion 2, or the holding portion may be formed after the blade edge portion 3.
(c) Although the holding portion 2 and the blade edge portion 3 are formed successively using the same grinding stone in the above embodiment, the present invention is not limited to this. The holding portion 2 and the blade edge portion 3 may be formed using different processing tools, and the holding portion 2 and the blade edge portion 3 may be processed at the same time using multiple grinding stones.
(d) Although the blade edge portion 3 is processed such that the blade width of the tip of the blade edge portion 3 becomes a desired width in the above embodiment, a configuration is possible in which the tip of the blade edge portion is formed with a sufficiently small width, and then the tip portion is processed such that the blade width of the tip of the blade edge portion 3 becomes a desired value.
(e) Although the tool is formed by grinding a round bar base member in the above embodiment, the base member is not limited to being shaped as a round bar.
(f) Although the tool main body 2 has the same diameter over its entire length in the above embodiment, a holding portion having a different diameter from the other portions may be formed in part of the tool main body 2. In this case, it is sufficient that the processing support portion 4 protrudes farther than the surface of the holding portion.
(g) The shape of the tool is not limited to the shape in the above embodiment, and the tool may be rectangular as shown in Fig. 6, for example. A tool 41 of this embodiment has a rectangular tool main body 42, a blade edge portion 43 formed on one end side of the tool main body 42, and a rectangular engaging portion 44 formed on the other end side of the tool main body 42. This tool 41 is formed by using a processing apparatus such as a milling machine to process a rectangular base member.

Similarly to the above embodiment, one portion (holding portion) of the tool main body 42 is held by the tool holder of the scribing apparatus 10. The blade edge portion 43 has the same width in the x direction (blade width) as the tool main body 42, but the thickness in the y direction orthogonal to the blade width gradually decreases toward the tip, and a portion of the tip is formed with the same thickness. The engaging portion 44 has the same thickness in the y direction as the tool main body 42, but the width in the x direction is larger so as to protrude outward from the two side surfaces of the tool main body 42.

Level differences of this engaging portion 44, that is to say lower surfaces 44a of the protruding portions, abut against protruding portions of the tool holder (not shown) from above. Accordingly, when the tool 41 is fixed to the tool holder, it is possible to prevent the tool 41 from falling downward due to vibration or the like.

### INDUSTRIAL APPLICABILITY

A substrate processing tool of the present invention can be prevented from falling out of a tool holder due to vibration during processing or the like.

### REFERENCE SIGNS LIST

- 1,41: Tool
- 2, 42: Tool main body (holding portion)
- 3, 43: Blade edge portion
- 4: Processing support portion (engaging portion)
- 44: Engaging portion

## Claims

1. A substrate processing tool for attachment to a substrate processing apparatus, the substrate processing tool comprising:
a tool main body, a holding portion to be held by a chuck portion of the substrate processing apparatus being formed in at least a portion of the tool main body;
a blade edge portion formed on one end side of the tool main body; and
an engaging portion formed on another end side of the tool main body, the engaging portion protruding farther than a surface of the tool main body.

2. The substrate processing tool according to claim 1, wherein a character is printed on the engaging portion, and no character is printed on the tool main body.

3. The substrate processing tool according to claim 1 or 2,
wherein the tool main body has a circular cross-sectional shape, and
the engaging portion has a circular cross-sectional shape and has a larger diameter than an outer diameter of the tool main body.

4. The substrate processing tool according to any of claims 1 to 3,
wherein the holding portion has a circular cross-sectional shape, and
the blade edge portion has a circular cross-sectional shape, and decreases in diameter from the holding portion toward a tip.

5. The substrate processing tool according to any of claims 1 to 4, wherein the holding portion and the blade edge portion are formed in the same step in a state where the tool is held by a chuck of a tool processing apparatus.
